# NEW EUROPEAN PATENT SPECIFICATION

(11) **EP 0 748 450 B2**
(45) Date of publication and mention of the opposition decision: **20.10.2004**
(45) Mention of the grant of the patent: 29.04.1998
(21) Application number: 95910516.4
(22) Date of filing: 23.02.1995
(51) Int. Cl.: G01R 1/073

(54) **PRINTED CIRCUIT BOARD TEST SET WITH TEST ADAPTER AND METHOD FOR SETTING THE LATTER**
LEITERPLATTENTESTANORDNUNG MIT TESTADAPTER UND METHODE ZUM AUSRICHTEN DESSEN
DISPOSITIF D'ESSAI DES PLAQUETTES DE CIRCUITS IMPRIMES DOTE D'UN ADAPTATEUR D'ESSAI, ET PROCEDE DE REGLAGE DE CELUI-CI

(30) Priority: 28.02.1994 DE 4406538
(43) Date of publication of application: 18.12.1996
(73) Proprietor: MANIA GmbH & Co., 61276 Weilrod (DE)
(72) Inventor: DRILLER, Hubert, D-61389 Schmitten (DE); MANG, Paul, D-61389 Schmitten (DE)
(74) Representative: Ruschke, Hans Edvard, Dipl.-Ing.
(86) International application number: PCT/EP1995/000662
(87) International publication number: WO 1995/023340

(56) References cited:
- EP-A- 0 508 561
- DE-A- 2 628 428
- DE-A- 3 722 485
- US-A- 5 225 777

## Description

The present invention relates to a printed circuit board test set with a test pin adapter and a method for setting the latter. This technology is used to connect the standard basic contact grid of an electronic test apparatus for single- or multilayer board-type interconnection substrates, such as printed circuit boards, ceramic substrates and similar, to the not necessarily grid-bonded contact points of the printed circuit board to be tested (interconnection substrate, test specimen), wherein said contact points are in the form of very small and very densely arranged metal contact areas ("pads") on one or both surfaces of the test specimen for SMD components and/or contact holes (plated-through holes) for "wired" components. The printed circuit boards are, in the case of the testing under discussion here, generally not yet loaded with such active electric/electronic components. It must be pointed out in this connection that the adapters currently preferred are so-called test pin adapters with test pins inside them, which are used in the printed circuit board test devices currently under discussion both for the single-sided and for the double-sided testing of printed circuit boards. However, other "contact elements" are also conceivable as test pins, such as so-called "vertical conductor rubber plates", i.e. for example rubber mats with contact wires finely distributed therein and disposed at right angles to the surface, or similar elastic mats which become live due to local pressure loads in this area, such are known in prior art.

As regards the testing of unloaded printed circuit boards, the limit of the testability was determined in the past mainly by the configuration possibility of the contact test pins in the adapter and by the contact density of the bonding pad (basic grid) of the printed circuit board test device. In keeping with the ever increasing miniaturization of electronic components, there has however occurred every year a further reduction in size of the electric conductor tracks and contact points and their density on the printed circuit boards to be tested. At the same time the size of the panels has had to be increased for utility-based production to the relatively large standard formats, i.e. the standard formats contain a number of identical printed circuit boards or printed circuits, in order thereby to optimize the economic return on the manufacture of the latter.

There therefore arises on an ever increasing scale the problem that the test pins in the supporting element of the adapter cannot be positioned sufficiently accurately in relation to the connecting structures (connecting areas, pads, holes) on the printed circuit board. This gives rise in many cases to defective and/or wrong contact points. These defective contactings make a reliable electrical test of these printed circuit boards extremely difficult or even impossible.

The causes of this problem lie (albeit on a reduced scale) in the adapter and above all in the test specimen itself. The influence of the adapter on the deviation of the contact points from the target value results both from the tolerances during the manufacture of the various components of the adapter and from the requisite clearance between e.g. the test pins and the guides provided for the latter (e.g. a number of drilled plexiglass plates as the supporting element) of the adapter:

| Accuracies of typical test adapters (excluding influence of the temperature during the testing) | |
|---|---|
| Deviation of the position of the tip of the contact elementrelative to the the centre of the guide element | ± 20 µm/± 0.8 mil |
| Overall clearance between guide element and guide hole in the insert | ± 25 µm/± 1.0 mil |
| Positional tolerance of the guide holes in the insert | ±05 µm/± 0.2 mil |
| Resulting in an overall deviation of | ± 50 µm/± 2.0 mil |
| "mil" means here a thousandth of an inch - this unit of length has acquired general acceptance in the printed circuit board industry - and amounts to 0,0254 mm. | |

The influence of the temperature during the manufacture and use of the adapter can be limited relatively easily by air conditioning measures. These measures can therefore be excluded from further consideration.

Far more difficult to control are the differences in the geometric structures on the test specimen, i.e. on the printed circuit board to be tested. These differences can be divided into relative positional displacements of the whole image, which can be attributed to recording errors during the exposure process, and to distortions within the image, which have arisen through irreversible thermal processes of the test specimen or of the film used for the exposure of the printed circuit. By virtue of the sequence of the production processes (drilling, exposure, hot tinning etc.) there are at least four mutually independent sources of error affecting the exact position of the conductor tracks and points of connection on the printed circuit board, i.e. the holes in the printed circuit board, the surface structure of the underside, the surface structure of the topside and the outer contour must be regarded as four mutually independent overall structures. Each of these overall structures possesses its own peculiar distortion/deformation properthes affecting the overall geometry of the useful object. The orientation of the overall structures to one another can be described by a displacement/distortion in X- and Y-direction and a rotation. For the individual printed circuit board in the panel the distortions can moreover be represented with sufficient accuracy as pure displacements and rotations.

Typically a "mixed technology" is used today. In the latter both wired components for connection to contact holes and surface-mountable (SMD) components for connection to contact areas or pads on a printed circuit board are provided. The grounds of the need for this mixed technology are that a number of electronic components, such as e. g. processors in high-pole PGA's (pin grid arrays) are not obtainable in surface-mounted form. Economic considerations or other technical factors also lead to this mixed technology.

The printed circuit boards manufactured for pure surface mounting can be aligned by means of conical reference pins for which the optimum position has been determined manually or optically. This kind of alignment, however, does not work for a large proportion of the printed circuit boards used today with the above-mentioned mixed technology, because the large number of conical test pins/contact elements provided for the contacting of the contact holes, when they are pressed against the test specimen, unintentionally displace the test specimen again into a false position, and hence cancel out the adjusting effect of e.g. two reference pins.

EP-A- 0 508 561 A1 shows an apparatus for electronically testing printed circuit boards including a plurality of generally parallel test pins which have a section of reduced diameter along their length intermediate the ends thereof with a plate having a plurality of drilled holes in which the test pins are mounted with the reduced diameter portions being located in the holes, the plate being adapted to interfere with shoulders at the ends of the sections of reduced diameter to retain the test pins in the testing apparatus. Any displacement of the test pins relative to each other (if any) only takes place in axial direction thereof, i.e. there is no movement whatsoever of any of the test pins relative to each other in a direction parallel with the printed circuit boards, let alone for the purpose of compensating any production errors in the exact location of any of the contact areas on the printed circuit boards to be tested.

US-A-5,225,777 discloses a high density test probe assembly and method of fabricating it. The probe assembly has a multitude of wire-like probe elements whose exposed tips are spaced on centers X and Y to match the centers of closely spaced surface pads of a VLSI circuit. Interconnections to and from the probe elements (for connection to external test equipment) are provided by a multi-layer arrangement of insulating and conducting layers within the body of the probe assembly. The tips of the probe elements are canted relative to vertical so that when the probe assembly is pushed down into mating position onto a VLSI circuit, the probe elements uniformly deflect laterally in one direction only and give a "wiping" action in contacting surface pads of the VLSI circuit together with a desired normal contact force. This prior art reference does not even mention the problem of laterally offset contact areas or pads on the object to be tested due to unavoidable production tolerances.

US Patent 4,820,975 describes an apparatus for testing PCBs and includes two test heads, one for each side of the board. Each test head carries an array of spring loaded probes for making electrical contact with the pads on the PCB. Each head also includes two optical fiber image guides for viewing alignment marks at diagonally opposite corners of the PCB, so as to indicate the degree of misalignment between the head and the PCB. The alignment can be adjusted by means of linear drive mechanisms which allow the position of the head to be adjusted in two dimensions relative to the PCB.

German Patent De 29 33 862 C2 shows a plate adapter for testing PCB's and forms the starting point for the present invention. A number of test pins for contacting the PCB to be tested are held and guided by two adapter plates which have been drilled by the same drilling program as the plated through-holes forming the contact points of the PCB under test. The tips of the test pins contact the PCB at contact positions which are located as needed whereas the opposing ends of the contact pins are flexed into contact with the regular grid of contacts on the PCB test apparatus. This prior art reference does not recognize or address the problem that the contacts of the PCB may not be in the position where they are expected to be as a result of the manufacturing process thereof.

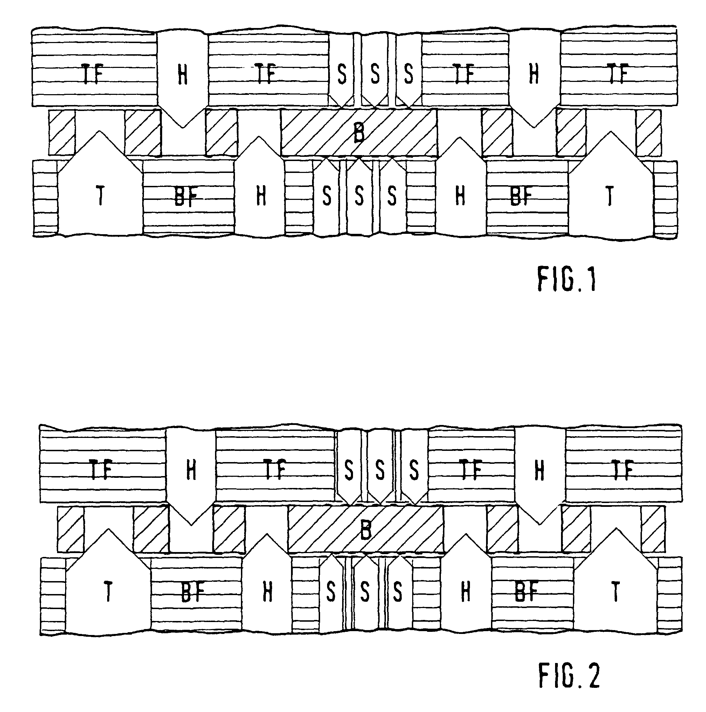

The attached Fig. 1 of the drawing shows the theoretically intended arrangement of contact elements or test pins during the double-sided testing of a printed circuit hoard B which is tested by means of a conventional adapting technology. The printed circuit board is here held in position by reference pins T and in the area of plated-through contact holes is contacted by relatively massive pins H and in the area of very small, closely arranged contact areas or pads on the board topside by thin, very closely arranged pins S.

Fig. 2 shows the defective alignment, resulting in fact from unavoidable fabrication inaccuracies during the manufacture of the reference pins, the test pins and the printed circuit board B to be tested, of a more or less large number of pins S in proportion to the very small contact areas for SMD components assigned to them, which results in correspondingly defective contactings of the test pins S if the conventional adapting technology is used. Since the holes in the printed circuit board B (for forming the at least two reference holes for the reference pins T and the in most cases very numerous through-platings for the test pins H) are produced in a different operating cycle to the "printed circuit" including the contact areas for the SMD components, it is impossible in practice, despite adequate miniaturization of the connecting structures on the printed circuit board B to be tested, to prevent the holes and the printed circuit together with the contact areas from undergoing a major unintentional displacement relative to one another, leading to the defective contacting, shown in Fig. 2, of one or more contact areas for SMD components by the pins S, which results in corresponding measurement errors in the testing of the printed circuit board B if the conventionally adapting technology is used. The defective alignment described above is however not caused simply by the possible defective alignment of the holes relative to the printed circuit, but to a large extent also by relative to the printed circuit, but to a large extent also by the fact that, by virtue of the production process for manufacturing the printed circuit, the latter deviates in the final analysis from its theoretically determined or intended position and dimension, i.e. it is applied to the board B inherently deformed or distorted or askew. Since however the guide holes for the pins T, H and S in the board TF or BF (TF = "top fixture" - top adapter; BF = "bottom fixture" - bottom adapter; S = "SMD sample - test pin for SMD pads; H = hole sample - test pin for contact holes) cannot be produced to take account of such accidentally occurring deviations and/or are themselves subject to certain fluctuations/tolerances in their position, it becomes clear that in the case of this conventional adapting technology with increasing miniaturization of the printed circuit boards to be tested, and with the increasing density in particular of the contact areas or pads for the SMD components, it is becoming increasingly difficult or even impossible to achieve a sufficiently accurate contacting in all contact points simultaneously of the printed circuit boards to be tested.

A further cause for the defective contacting of the printed circuit boards to be tested, which is frequently observed during the conventional adapting despite the (supposed) fixing of the latter to a predetermined position by means of the reference pins T, is based on the fact that during the pressing of the printed circuit board in the course of the test operation onto the possibly very numerous test pins H the latter in certain circumstances simply cancel out the intrinsically provided and intended alignment effect of the reference pins. For since the exact position of the individual test pins H provided with a cone point, which engage with the holes of the through-platings, is naturally also subject to certain fluctuations, and namely not only in relation to the respective position of the holes accomodating the pins H, but also because the cone points of these pins H are by no means always accurately disposed centrally, it can easily happen that the actual position of the printed circuit board B, when the printed circuit board is in the pressed state for the test operation, is determined very much more by the large mass of the test pins H than by the in most cases two reference pins T and hence is also somewhat accidental.

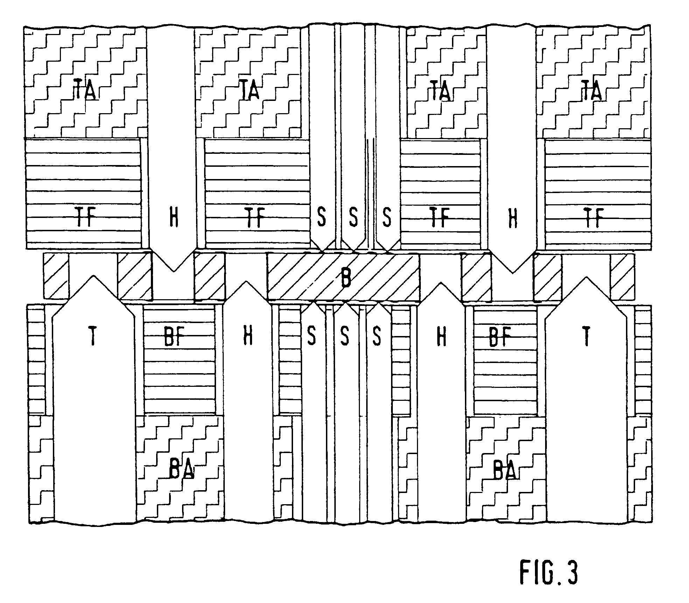

A solution to this problem will be explained with reference to Fig. 3, which shows a possible form of execution of the invention by means of a cutout from a printed circuit board test device with a novel test pin adapter on the top side and underside of a test specimen B. This solution utilizes a plurality of sections of the supporting elements, which sections, e.g. subdivided into various planes and disposed on one particular side of the test specimen B, are in the form of adapter plates which are freely positionable independently of one another relative to the test specimen within limited regions relative to the test specimen. Fig. 3 thus shows the essence of the novel adapting technology, which is distinguished above all by the fact that the test pins S for the contacting of the very small and densely arranged surface contacts of SMD components on the printed circuit board are accommodated in holes in a section of the guide element namely in an adapter board BF or TF, which is (are) displaceable by a significant dimension parallel with the printed circuit board plane in relation to the test pins H and the reference pins T and hence to the test specimen, wherein this dimension must conform at least to the greatest anticipated defective alignment of the test pins S by the surface contacts of the printed circuit board to be tested which are assigned to them.

For the spacing of the various guide plates of a test pin adapter a sequence presents itself which takes account both of the accuracy requirements concerning the test pins guided by the latter and of the mechanical stability properthes of the latter: the more slender and hence more flexible test pins for connection to the contact areas or pads are accommodated in the guide plate of the test pin adapter which lies closest to the respective printed circuit board, since the positioning of these contact elements/test pins F requires, by virtue of the high contact density of these small contact areas and the high flexibility of the thin test pins, the greatest possible accuracy.

For the contact elements intended to follow the loading with wired components, holes/vacancies are used whose dimensions are increased to such an extent that a lateral movement of these contact elements within the required tolerances is possible. The great stability of these typically more stable contact elements, combined with the self-centring of the conical tips in the holes of the test specimen, permits guiding without difficulty through an independent, further removed adapter plate. The contact elements for the "pads", which of necessity penetrate this second adapter plate on the respective printed circuit board side, are guided through enlarged holes/vacancies in a similar manner, so that an independent precision positioning is possible.

For the positioning of the test specimen in the adapter, reference holes are generally used which are produced simultaneously with the standard drilling process for through-platings or component holes. For this case it is essential that the alignment means (e.g. reference pins) required for the pre-centring during the manual or automatic insertion of the printed circuit board to be tested be positioned on the same support plate as is used for the contacting of the terminals for wired components. This is possible if all the holes in the printed circuit board, including the reference holes, possess a common distortion and displacement structure.

In special cases the reference holes are produced together with the milling of the outer contour as a last production step. In this case it may be necessary to provide a further support element section for the positioning, which can be positioned independently of the other sections relative to the test specimen.

In each case it is highly recommendable that a steadily pressed-in barrel be used for the guiding of the "reference pins". Such a barrel, typically reaching close to the test specimen, prevents lateral spreading/warping of this alignment means (reference pin) despite the necessary clearance for the vertical movement, normally supported by a spring, of the reference pin.

Although the reference holes produced together with the outer contour on accuracy grounds in special cases in the past theoretically exhibit better accuracy by virtue of the absence of a plated-through hole barrel, the use of plated-through reference holes is nevertheless to be recommended, because the overall work-load for the testing is reduced and the collection of the many contact elements with typically conical tip for the contacting of the terminals for wired components permits a substantially better centring. The law of large numbers operates here, which produces for the overall positioning accuracy the mean value of the distribution frequency, contingent on manufacturing tolerances, around the target value of the positioning. In mathematical terms there is obtained as the probable deviation the statistical error of the mean value. Consequently the differences produced by slightly varying wall thicknesses of the plated-through barrels are more than offset.

Two methods can be used in principle for determining the position for the alignment of the support plates by alignment or contact elements:

The simplest (first) method is a common positioning for a lot. This method can only be used effectively, however, if the fluctuations in the distortions/displacements occurring within a lot are small compared with the total deviation to be corrected. Elaborate measuring and subsequent positioning is inappropriate in this case. For the test specimens lying at the extreme edge of the contact points position errors-distribution curve there will then be added as a follow-up to the test of the lot an additional labour- and time-intensive phase, in which the printed circuit boards exhibiting faults (typically breaks) are tested with manually optimized displacement values.

In the second method an alignment takes place for each individual printed circuit board. To enable optimum displacement values to be set directly for each test specimen in the first test, optical measuring devices, such as e.g. CCD cameras, are generally used. These cameras measure the position of marks which are provided additionally for the optical, recording. These marks are present on almost all test specimens, so that the fully automatic loading devices used later can load the printed circuit board later with surface-mounted components. This means therefore that a special measuring apparatus or station is required, which prior to the printed circuit board test proper measures the displacement of the printed circuit of each board by means of graphic elements in the "image" of the printed circuit board.

Since in the double-sided testing of printed circuit boards - as mentioned above - very many position error degrees of freedom exist, a corresponding number of cameras also have to be used for this second method. There is obtained as a minimum for the latter a number of two cameras on each printed circuit board side to be tested, in order to determine for each side the actual orientation in the three degrees of freedom (X- and Y-axis, angle). In practice these cameras cannot be accommodated in the test adapter, even with extreme miniaturization, since the optical recording marks lie very close to or between the contact points to be tested. A remedy is provided here by the above-mentioned special measuring apparatus or station, in which the test specimens are measured optically prior to the test proper. This measurement can be carried out in the simplest manner in a fully automatic test system, because then the test specimens can pass through a synchronously operating twin station, in which in the first station measurements are made and in the second station (the test adapter) testing is carried out with optimum positioning with the displacement values thereby determined.

In the measuring station there can be used per side either one camera positionable freely in X/Y direction or two cameras recorded through exact positioning holes in the adapter. The first case increases the mechanical outlay on the system side (one-off procurement costs), because a high-precision positioning device is required. The second case requires greater expenditure on each adapter, which has to be developed individually for each individual printed circuit board (series).

In a fully automatic test system, in which the conveyance to the actual test adapter takes place by means of a control system which is able to monitor highly accurately the location of the test specimen during the conveyance, alternative methods exist for measuring the displacement of the printed circuit on the printed circuit board relative to the holes. For example, the position of alignment marks can be measured in such a way that a reflexion light barrier measures the reflexivity of the surface of the test specimen either directly or indirectly across a certain distance by means of a fibre-optic light guide. the degree of intensity measured during the movement permits an accurate computer-aided calculation of the displacement values. The degree of accuracy required of the conveyance means can also be reduced if a straight forward incremental measurement between the printed circuit board print and the holes is used. For this there can be provided e.g. a hole in a preferably rectangular metal area (pad), during the optical scanning of which an intensity profile is then obtained whose deviation from a predetermined profile or whose asymmetry mirrors very accurately the displacement values.

In order to become as independent as possible of the contamination problems encountered in everyday production runs, use can also be made, instead of optical measurement, of mechanical scanning (pick-up). For example, a sapphire pin or a subminiature sapphire roll with connected structure-borne noise amplifier scans the surface of the printed circuit board. The edges of a metal area on the test specimen relative to the support material or relative to a hole then give clearly differentiatable (sonar) pulse shapes whose symmetrical or asymmetrical position provides clear evidence of displacement (sonar pattern).

The measuring techniques described above provide the possibility, prior to the test run proper, during which the printed circuit on the test specimen is verified by the contacting of possibly thousands of test pins, of carrying out a measurement of the displacement. The result of the measurement is then used directly for the adjustment of alignment elements in the adapter, so that the adapting device is optionally positioned individually for each individual test specimen. This advantageous result is made possible by the work undertaken during the measurement of the displacement values.

Should it be decided on economic grounds or because of reduced accuracy requirements not to use one of the above-mentioned methods, there is a further method which requires a small work-load, but can only be used "post factum":

Use is made there of the fact that the displacement values found within a single lot vary far less than those between lots (tracking production parameters). Within the adapter that is used for the electrical testing there are accommodated, in addition to the test pins or contact elements that are required for the actual testing of the connection pattern or the printed circuit, further displacement test pins, which interact with a special "test pattern" or alignment marks on the printed circuit board. These additional displacement test pins are so arranged that they supply, in the event of increasing displacement of the board pattern, an increasingly varying displacement measurement result. Should one or more faults be discovered during the electrical testing, therefore, there can be established of the separately recorded, additional displacement measurement result the direction, and in some cases a value, for the displacement coorection required. After a corresponding mechanical adjustment t=of the alignment means in the adapter the same printed circuit board is then tested once again. The additional displacement test pins introduced for the displacement measurement can moreover be connected either to the conventional printed circuit board test set itself or to an external electronic unit and be evaluated by the latter. In special cases there will in addition be determined by means of the relationship with the mechanical displacement values the optimized position of the adapter relative to the test specimen. A structural combination of this external electronic evaluation until with the mechanical control unit for adjusting the alignment means on the adapter makes a compact solution or assembly with user-friendly operation possible. This leads to a twin station with a Station A "Sensor" with the optical or electrical displacement measurement and a Station B "Tester" with the mechanical setting of the adapter based on the measurement result. The electric displacement sensor operates by means of alignment marks, including for pure SMD application, Le. without "mixed" technology with subset displacement.

The adapter according to the invention can also be constructed for a "mixed" manufacturing technology by division (partitioning) of the guide element in the plane of the guide element, if the structure on the printed circuit board exhibit adequate geometric spacings.

## Claims

1. Method for setting the contact elements of a printed circuit board test set to the contact points provided on one side of an unloaded mixed-technology printed circuit board for testing the same, which contact elements are accommodated in a test adapter with a supporting element adjacent to the printed circuit board, the supporting element having adapter plates accommodating the contact elements (H, S) for maintaining the latter in test-specimen-specific alignment with the contact points of the printed circuit board (B), wherein said printed circuit board possesses various subsets of contact points and suitable alignment means with respect to the test adapter, in particular, two reference holes or reference edges, and wherein at least one subset (S, S, S) of the contact elements (H, S), accommodated by one of the adapter plates, and alignment means (T) of the test adapter are set relative to one another and thus independently of at least one further subset of the contact elements by a significant dimension, parallel with the printed circuit board plane.

2. Method according to claim 1, **characterized in that** the subset (S, S, S) of the contact elements (H, S) of the adapter which pertains to the smallest contact points of the printed circuit board (B) is set.

3. Method according to claim 1 or 2, **characterized in that** the setting of the at least one contact element subset of the adapter takes place on the basis of a previously conducted measurement of the production-determined variable actual position of the contact points of the printed circuit board (B), i. e. of its deviation from the target position, in proportion to the alignment means (T).

4. Method according to claim 3, **characterized in that** the measurement takes place by means of a number of position measurement contact elements which impinge on an electrically conductive position measurement image disposed on the printed circuit board, wherein said electrically conductive position measurement image forms part of the geometric structures on the printed circuit board and supplies as a function of their actual position various electrical measurement results which provide a bench-mark for the required setting.

5. Method according to claim 3, **characterized in that** the measurement takes place by means of a number of position measurement cameras which scan one or more alignment marks disposed on the printed circuit board which form part of the geometric structures on the printed circuit board and supply as a function of their actual position, various electrical measurement results which provide a bench-mark for the required setting.

6. Apparatus for setting the contact elements (H, S) of a printed circuit board test set, which contact elements are accommodated in a test adapter, to the contact points of an unloaded mixed-technology printed circuit board to be tested on one side, with a supporting element adjacent to the printed circuit board (B), the supporting element having adapter plates accommodating the contact elements (H, S) for maintaining the latter in test-specimen-specific alignment with the contact points of the printed circuit board (B), and with suitable alignment means (T) for positioning the printed circuit board in relation to the test adapter, wherein at least one adapter plate accommodating a subset (S, S, S) of the contact elements (H, S) is to a limited extent adjustable independently of the alignment means (T) and of the rest of the contact elements of the test adapter, in parallel with the printed circuit board.

7. Apparatus according to claim 6, **characterized in that** the adapter plate of the supporting element directly adjoining the printed circuit board (B) guides the contact element subset (S, S, S) assigned to the smallest test points and that the adapter plate(s) of the supporting element removed increasingly further from the test specimen guides the contact element subset(s) assigned to the increasingly larger contact points.

8. Apparatus according to any one of the preceding claims, **characterized in that** each adapter plate of the supporting element exhibits around the contact elements accommodated in other adapter plates of the supporting element large free spaces in order to permit the limited adjustment of the sections to one another and of the contact element subsets accommodated therein.

9. Apparatus according to any one of the preceding claims, **characterized in that** one of the autonomously adjustable adapter plates of the supporting element of the test adapter bears the alignment means and corresponding free spaces are provided for the latter in the other adapter plate of the supporting element.

10. Apparatus according to any one of the preceding claims, **characterized by** a number of optico-electric or electric position measuring devices which scan one or more optical or electrically conductive alignment marks disposed on the printed circuit board, wherein said alignment marks form part of the geometric structures on the printed circuit board and supply as a function of the actual position of the latter various electric measurement results which provide a bench-mark for the required relative setting in proportion to one another of the alignment means and the at least one adapter plate adjustable to a limited extent of the supporting element of the at lest one test adapter.

11. Apparatus according to claim 10, **characterized in that** the setting relative to one another of the alignment means and the adapter plate of the supporting element adjustable to a limited extent takes place by means of one or more electric-motor drives, e. g. eccentric drives.

12. Apparatus according to claim 10 or 11, **characterized in that** the position measurement devices and the electric-motor setting drives are disposed on areas of a printed circuit board test device physically separate from one another.

## Patentansprüche

1. Verfahren zum Einstellen der Kontaktelemente einer Leiterplatten-Prüfvorrichtung auf die Kontaktpunkte auf einer Seite einer unbestückten zu prüfenden Leiterplatte der gemischten Technologie, wobei die Kontaktelemente in einem Testadapter mit einem abstützenden Element neben der Leiterplatte untergebracht sind, wobei das abstützende Element Adapterplatten hat, die Kontaktelemente (H, S) zum Festlegen der letzteren in prüflingsspezifischer Ausrichtung auf die Kontaktpunkte der Leiterplatte (B) beherbergen, wobei die Leiterplatte verschiedene Untermengen von Kontaktpunkten und geeignete Ausrichtmittel bezüglich des Testadapters besitzt, insbesondere zwei Referenz-Löcher oder Referenz-Kanten, und wobei wenigstens eine Untermenge (S, S, S) der Kontaktelemente (H, S), die von einer der Adapterplatten beherbergt wird, und Ausrichtmittel (T) des Testadapters relativ zu einander und damit unabhängig von mindestens einer weiteren Untermenge der Kontaktelemente um eine signifikante Abmessung parallel zur Ebene der Leiterplatte eingestellt werden.

2. Verfahren nach Anspruch 1, **dadurch gekennzeichnet, daß** man diejenige Untermenge (S, S, S) der Kontaktelemente (H, S) des Adapters einstellt, die die kleinsten Kontaktpunkte der Leiterplatte betrifft.

3. Verfahren nach Anspruch 1 oder 2, **dadurch gekennzeichnet, daß** die Einstellung der mindestens einen Kontaktelement-Untermenge des Adapters aufgrund einer vorhergehenden Messung der fertigungsbestimmt variablen Istposition der Kontaktpunkte auf der Leiterplatte (B) stattfindet, d. h. aufgrund deren Abweichung von der Sollage, relativ zum Ausrichtmittel (T).

4. Verfahren nach Anspruch 3, **dadurch gekennzeichnet, daß** die Messung mittels einer Anzahl von Positionsmessungs-Kontaktelementen erfolgt, die auf ein elektrisch leitfähiges Positionsmeßbild auf der Leiterplatte aufsetzen, wobei das elektrisch leitfähige Positionsmeßbild Teil der geometrischen Strukturen auf der Leiterplatte ist und als Funktion seiner Istlage verschiedene elektrische Meßergebnisse liefert, die als Richtlinie für die erforderliche Einstellung dienen können.

5. Verfahren nach Anspruch 3, **dadurch gekennzeichnet, daß** die Messung mittels einer Anzahl von Positionsmeßkameras erfolgt, die eine oder mehrere Ausrichtmarkierungen auf der Leiterplatte abtasten, die Teil der geometrischen Strukturen auf der Leiterplatte bilden, und als Funktion ihrer Istposition verschiedene elektrische Meßergebnisse liefern, die als Richtlinie für die erforderliche Einstellung dienen können.

6. Vorrichtung zum Einstellen der Kontaktelemente (H, S) einer Leiterplatten-Prüfvorrichtung auf die Kontaktpunkte einer einseitig zu prüfenden unbestückten Leiterplatte der gemischten Technologie, mit einem abstützenden Element neben der Leiterplatte (B), das Adapterplatten zum Unterbringen der Kontaktelemente (H, S) in prüflingsspezifischer Ausrichtung auf die Kontaktpunkte der Leiterplatte (B) hat, sowie mit geeigneten Ausrichtmitteln (T) zum Positionieren der Leiterplatte im Verhältnis zu dem Testadapter, wobei zumindest eine Adapterplatte, die eine Untermenge (S, S, S) der Kontaktelemente (H, S) beherbergt, in einem beschränkten Ausmaß unabhängig von dem Ausrichtmittel (T) und dem Rest der Kontaktelemente des Testadapters parallel zu der Leiterplatte einstellbar ist.

7. Vorrichtung nach Anspruch 6, **dadurch gekennzeichnet, daß** die unmittelbar neben der Leiterplatte (B) gelegene Adapterplatte des abstützenden Elementes die den kleinsten Prüfpunkten zugewiesene Kontaktelement-Untermenge (S, S, S) führt und daß die vom Prüfling zunehmend entfernte(n) Adapterplatte(n) des abstützenden Elementes die den zunehmend größeren Kontaktpunkten zugeordneten Kontaktelement-Untermenge(n) führt.

8. Vorrichtung nach einem der vorhergehenden Ansprüche, **dadurch gekennzeichnet, daß** jede Adapterplatte des abstützenden Elementes um die von anderen Adapterplatten des abstützenden Elementes aufgenommenen Kontaktelemente herum große Freiräume aufweist, um die begrenzte Einstellbarkeit der Bereiche relativ zueinander und der von ihnen aufgenommenenen Kontaktelemente-Untermengen zu ermöglichen.

9. Vorrichtung nach einem der vorhergehenden Ansprüche, **dadurch gekennzeichnet, daß** eine der unabnhängig einstellbaren Adapterplatten des abstützenden Elementes des Prüfadapters die Ausrichtmittel trägt und daß entsprechende Freiräume für letztere in den anderen Bereichen des abstützenden Elementes vorgesehen sind.

10. Vorrichtung nach einem der vorhergehenden Ansprüche, **dadurch gekennzeichnet, daß** eine Anzahl elektrooptischer oder elektrischer Positionsmeßeinrichtungen, die eine oder mehrere optische oder elektrisch leitfähige Ausrichtmarkierungen abtasten, die sich auf der Leiterplatte befinden, wobei die Ausrichtmarkierungen Teil der geometrischen Strukturen auf der Leiterplatte sind und entsprechend der Istposition der letzteren verschiedene elektrische Meßergebnisse als Richtlinie für die erforderliche relative Einstellung der Ausrichteinrichtungen und der mindestens einen begrenzt einstellbaren Adapterplatte des abstützenden Elementes des mindestens einen Prüfadapters liefern.

11. Vorrichtung nach Anspruch 10, **dadurch gekennzeichnet, daß** das gegenseitige Einstellen der Ausrichteinrichtung und der begrenzt einstellbaren Adapterplatte des abstützenden Elementes mittels eines oder mehrerer elektromotorischer Antriebe - beispielsweise Exzenterantriebe - erfolgt.

12. Vorrichtung nach Anspruch 10 oder 11, **dadurch gekennzeichnet, daß** die Positionsmeßeinrichtungen und die elektromotorischen Einstellantriebe sich in voneinander getrennten Bereichen einer Leiterplatten-Prüfvorrichtung befinden.

## Revendications

1. Procédé pour amener les éléments de contact d'un dispositif de test de plaquettes de circuits imprimés aux points de contact prévus sur un côté d'une plaquette de circuits imprimés à technologie mixte non chargée à contrôler, lesquels éléments de contact sont logés dans un adaptateur de test ayant un élément support adjacent à la plaquette de circuits imprimés, l'élément support ayant des plaques d'adaptateur recevant les éléments de contact (H, S) pour maintenir ces derniers dans un alignement spécifique de spécimen à contrôler avec les points de contact de la plaquette de circuits imprimés (B), dans lequel ladite plaquette de circuits imprimés possède divers sous-groupes de points de contact et des moyens d'alignement appropriés par rapport à l'adaptateur de test, en particulier deux trous de référence ou bords de référence, et dans lequel au moins un sous-groupe (S, S, S) des éléments de contact (H, S) logés par une des plaques d'adaptateur, et les moyens d'alignement (T) de l'adaptateur de test sont réglés les uns par rapport aux autres et ainsi indépendamment d'au moins un autre sous-groupe des éléments de contact d'une dimension significative, parallèlement au plan de la plaquette de circuits imprimés.

2. Procédé selon la revendication 1, **caractérisé en ce que** le sous-groupe (S, S, S) des éléments de contact (H, S) de l'adaptateur qui appartient aux points de contact les plus petits de la plaquette de circuits imprimés (B) est réglé.

3. Procédé selon la revendication 1 ou 2, **caractérisé en ce que** le réglage d'au moins un sous-groupe d'éléments de contact de l'adaptateur s'effectue sur la base d'une mesure précédemment conduite de la position réelle variable déterminée à la production des points de contact de la plaquette de circuits imprimés (B), c'est-à-dire de son écart par rapport à la position cible, en proportion des moyens d'alignement (T).

4. Procédé selon la revendication 3, **caractérisé en ce que** la mesure s'effectue au moyen d'un nombre d'éléments de contact de mesure de position qui tombent sur une image de mesure de position électriquement conductrice disposée sur la plaquette de circuits imprimés, dans lequel ladite image de mesure de position électriquement conductrice fait partie des structures géométriques de la plaquette de circuits imprimés et fournit, en tant que fonction de leurs positions réelles, divers résultats de mesures électriques qui procurent un point de repère pour le positionnement exigé.

5. Procédé selon la revendication 3, **caractérisé en ce que** en la mesure s'effectue au moyen d'un nombre de caméras de mesure de position qui balaient une ou plusieurs marques d'alignement disposées sur la plaquette de circuits imprimés qui font partie des structures géométriques sur la plaquette de circuits imprimés et fournissent, eh fonction de leurs positions réelles, divers résultats de mesures électriques qui procurent un point de repère pour le positionnement exigé.

6. Appareil pour positionner les éléments de contact (H, S) d'un dispositif de test de plaquettes de circuits imprimés, lesquels éléments de contact sont logés dans un adaptateur de test, aux points de contact d'une plaquette de circuits imprimés à technologie mixte déchargée à contrôler sur un côté, avec un élément support adjacent à la plaquette de circuits imprimés (B), l'élément support ayant des plaques d'adaptateur recevant les éléments de contact (H, S) pour maintenir ces derniers dans un alignement spécifique de spécimen à contrôler avec les points de contact de la plaquette de circuits imprimés (B), et avec des moyens d'alignement appropriés (T) pour positionner la plaquette de circuits imprimés par rapport à l'adaptateur de test, dans lequel au moins une plaque d'adaptateur recevant un sous-groupe (S, S, S) des éléments de contact (H, S) est à un degré limité réglable indépendamment des moyens d'alignement (T) et du reste des éléments de contact de l'adaptateur de test, parallèlement à la plaquette de circuits imprimés.

7. Appareil selon la revendication 6, **caractérisé en ce que** la plaque d'adaptateur de l'élément support directement adjacente à la plaquette de circuits imprimés (B) guide le sous-groupe d'éléments de contact (S, S, S) affectés aux plus petits points de test, et que la (les) plaque(s) d'adaptateur de l'élément support retirée(s) progressivement du spécimen à contrôler guide (guident) le (les) sous-groupe(s) d'éléments de contact affecté(s) aux points de contact progressivement plus grands.

8. Appareil selon l'une quelconque des revendications précédentes, **caractérisé en ce que** chaque plaque d'adaptateur de l'élément support présente, autour des éléments de contact logés dans d'autres plaques d'adaptateur de l'élément support, de grands espaces libres afin de permettre le réglage limité des sections l'une par rapport à l'autre et des sous-groupes d'éléments de contact logés à l'intérieur.

9. Appareil selon l'une quelconque des revendications précédentes, **caractérisé en ce que** l'une des plaques d'adaptateur réglable de façon autonome de l'élément support de l'adaptateur de test porte les moyens d'alignement, et **en ce que** des espaces libres correspondants sont prévus pour ces derniers dans l'autre plaque d'adaptateur de l'élément support.

10. Appareil selon l'une quelconque des revendications précédentes, **caractérisé par** un nombre de dispositifs de mesure de position opto-électriques ou électriques qui balayent une ou plusieurs marques d'alignement optiques ou électriquement conductrices disposées sur la plaquette de circuits imprimés, dans lequel lesdites marques d'alignement font partie des structures géométriques sur la plaquette de circuits imprimés et fournissent, en fonction de la position réelle de la dernière mesure électrique variée, des résultats qui procurent un point de repère pour le réglage relatif exigé en proportion de l'un à l'autre des moyens d'alignement et d'au moins une plaque d'adaptateur réglable à un degré limité de l'élément support du au moins un adaptateur de test.

11. Appareil selon la revendication 10, **caractérisé en ce que** le réglage de l'un par rapport à l'autre des moyens d'alignement et de la plaque d'adaptateur de l'élément support réglable à un degré limité s'effectue au moyen d'un ou de plusieurs entraînements par moteur électrique, par exemple des entraînements excentriques.

12. Appareil selon la revendication 10 ou 11, **caractérisé en ce que** les dispositifs de mesure de position et les entraînements de réglage par moteur électrique sont disposés sur des zones d'un dispositif de test de la plaquette de circuits imprimés physiquement séparées les unes des autres.
